# EUROPEAN PATENT SPECIFICATION

(11) **EP 3 427 153 B1**
(45) Date of publication and mention of the grant of the patent: **27.05.2020**
(21) Application number: 17707143.8
(22) Date of filing: 09.02.2017
(51) Int. Cl.: G06F 12/02, G06F 13/16, G11C 7/10, G06F 12/10, G06F 12/1081, G06F 12/08, G06F 12/06, G06F 12/0802, G11C 8/12

(54) **MULTI-RANK COLLISION REDUCTION IN A HYBRID PARALLEL-SERIAL MEMORY SYSTEM**
MEHRRANGIGE KOLLISIONSVERRINGERUNG IN EINEM HYBRIDEN PARALLEL-SERIELLEN SPEICHERSYSTEM
RÉDUCTION DE COLLISION DE RANGÉES MULTIPLES DANS UN SYSTÈME DE MÉMOIRE HYBRIDE PARALLÈLE-SÉRIE

(30) Priority: 11.03.2016 US 201615068184
(43) Date of publication of application: 16.01.2019
(73) Proprietor: Qualcomm Incorporated, San Diego, CA 92121-1714 (US)
(72) Inventor: CHUN, Dexter Tamio, San Diego, CA 92121 (US); LI, Yanru, San Diego, CA 92121 (US); JAFFARI, Javid, San Diego, CA 92121 (US); ANSARI, Amin, San Diego, CA 92121 (US)
(74) Representative: Wegner, Hans
(86) International application number: PCT/US2017/017191
(87) International publication number: WO 2017/155662

(56) References cited:
- WO-A1-2013/100975
- US-A- 5 649 124
- US-A1- 2004 187 122
- US-A1- 2015 046 732
- US-A1- 2015 317 277
- US-A1- 2015 364 162

## Description

### DESCRIPTION OF THE RELATED ART

Portable computing devices (*e.g.,* cellular telephones, smart phones, tablet computers, portable digital assistants (PDAs), portable game consoles, wearable devices, and other battery-powered devices) and other computing devices continue to offer an ever-expanding array of features and services, and provide users with unprecedented levels of access to information, resources, and communications. To keep pace with these service enhancements, such devices have become more powerful and more complex. Portable computing devices now commonly include a system on chip (SoC) comprising various memory clients embedded on a single substrate (*e.g.,* one or more central processing units (CPUs), a graphics processing unit (GPU), digital signal processors, *etc*.). The memory clients may request read and write transactions from a memory system.

The SoC may be electrically coupled to the memory system by both a parallel access channel and a separate serial channel. Hybrid parallel-serial memory access can provide increased bandwidth without an increased cost and number of pins required to increase bandwidth through parallel memory access channels. In such systems, however, memory is randomly allocated across physical addresses associated with the serial and parallel access channels, which can result in inefficient memory traffic access. This inefficiency can be worsened due to physical memory fragmentation. Furthermore, memory collisions may occur between the serial and parallel access channels.

Document US 2015/317277 A1 refers to a computer and a memory system that provides both parallel and serial memory buses between a system of processors and a memory. In order to increase the memory bus bandwidth, said document discloses a combination of a low-latency parallel memory bus with a high-latency, but, high-speed, serial memory bus. The memory system is external to an integrated circuit (IC), wherein said IC provides a single-chip heterogeneous processor system including a general processor and a more specialized processor. The former processor (latency sensitive) has less tolerance to latency regarding the communication between the processor and the external memory system than the specialized processor (latency-insensitive), wherein the latency is distinct from the data rate. Thus, when a processor sends a read request to the external memory, said processor may assign a memory allocation task and may provide signals to a memory management unit (external memory controller) and map the data used by the processor system to the memory banks.

Document US 2015/046732 A1 discloses two or more memory devices for which the configuration of memory address map is accessed via two or more respective memory channels with an interleaved region and a linear region, based on a hint provided in the memory access request.

Document US5649124 A discloses using a serial access interface and a parallel access interface coupled to access a memory device by simultaneously writing transaction request to both dedicated serial and parallel access regions.

Document US 2004/187122 A1 discloses a virtual memory system, wherein the paging process is handled by a supplemental memory manager that uses a hint, optionally provided by the kernel mode driver on creation of a particular allocation. The hint was created to find an appropriate location in memory for a memory resource.

Accordingly, there is a need for improved systems and methods for allocating memory in a hybrid parallel-serial memory system.

### SUMMARY OF THE DISCLOSURE

The present invention is defined in the appended independent claims to which reference should be made. Advantageous features are set out in the appended dependent claims.

The embodiments or examples of the following description which are not covered by the appended claims are considered as not being part of the invention.

Systems, methods, and computer programs are disclosed for allocating memory in a hybrid parallel/serial memory system. One method comprises configuring a memory address map for a multi-rank memory system with a dedicated serial access region in a first memory rank and a dedicated parallel access region in a second memory rank. A request is received for a virtual memory page. If the request comprises a performance hint, the virtual memory page is selectively assigned to a free physical page in the dedicated serial access in the first memory rank and the dedicated parallel access region in the second memory rank.

Another embodiment is a system for allocating memory in a hybrid parallel/serial memory system. The system comprises a multi-rank memory system electrically coupled to a system on chip (SoC) via a serial bus and a parallel bus. The multi-rank memory system comprises a first memory rank and a second memory rank. The SoC comprises a memory allocator configured to: receive a request for a virtual memory page; and if the request comprises a performance hint, selectively allocate the virtual memory page to a free physical page in a dedicated serial access region in the first memory rank and a dedicated parallel access region in the second memory rank.

### BRIEF DESCRIPTION OF THE DRAWINGS

In the Figures, like reference numerals refer to like parts throughout the various views unless otherwise indicated. For reference numerals with letter character designations such as "102A" or "102B", the letter character designations may differentiate two like parts or elements present in the same Figure. Letter character designations for reference numerals may be omitted when it is intended that a reference numeral to encompass all parts having the same reference numeral in all Figures.
FIG. 1 is a block diagram of an embodiment of a system for allocating memory in a multi-rank memory system having hybrid parallel-serial access.
FIG. 2 is a combined block/flow diagram illustrating an embodiment of a multi-rank dual inline memory module (DIMM).
FIG. 3 is a data diagram illustrating an exemplary memory address map for the multi-rank DIMM of FIG. 2.
FIG. 4 is a flowchart illustrating an embodiment of a method for allocating memory in a multi-rank memory system having hybrid parallel-serial access.
FIG. 5 is a data diagram illustrating an exemplary flag structure for providing a performance hint to the memory allocator in FIG. 1.
FIG. 6 is a data diagram illustrating the memory address map of FIG. 3 for providing multiple channels.
FIG. 7 is a block diagram of an embodiment of a portable communication device for incorporating the system of FIG. 1.

### DETAILED DESCRIPTION

The word "exemplary" is used herein to mean "serving as an example, instance, or illustration." Any aspect described herein as "exemplary" is not necessarily to be construed as preferred or advantageous over other aspects.

In this description, the term "application" may also include files having executable content, such as: object code, scripts, byte code, markup language files, and patches. In addition, an "application" referred to herein, may also include files that are not executable in nature, such as documents that may need to be opened or other data files that need to be accessed.

The term "content" may also include files having executable content, such as: object code, scripts, byte code, markup language files, and patches. In addition, "content" referred to herein, may also include files that are not executable in nature, such as documents that may need to be opened or other data files that need to be accessed.

As used in this description, the terms "component," "database," "module," "system," and the like are intended to refer to a computer-related entity, either hardware, firmware, a combination of hardware and software, software, or software in execution. For example, a component may be, but is not limited to being, a process running on a processor, a processor, an object, an executable, a thread of execution, a program, and/or a computer. By way of illustration, both an application running on a computing device and the computing device may be a component. One or more components may reside within a process and/or thread of execution, and a component may be localized on one computer and/or distributed between two or more computers. In addition, these components may execute from various computer readable media having various data structures stored thereon. The components may communicate by way of local and/or remote processes such as in accordance with a signal having one or more data packets (*e.g.,* data from one component interacting with another component in a local system, distributed system, and/or across a network such as the Internet with other systems by way of the signal).

In this description, the terms "communication device," "wireless device," "wireless telephone", "wireless communication device," and "wireless handset" are used interchangeably. With the advent of third generation ("3G") wireless technology and fourth generation ("4G"), greater bandwidth availability has enabled more portable computing devices with a greater variety of wireless capabilities. Therefore, a portable computing device may include a cellular telephone, a pager, a PDA, a smartphone, a navigation device, or a hand-held computer with a wireless connection or link.

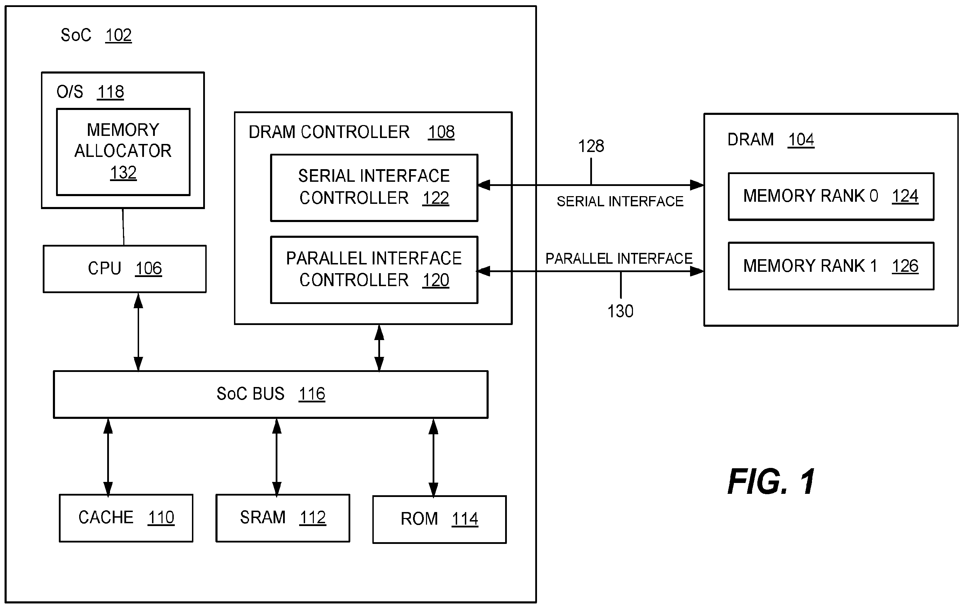

FIG. 1 illustrates an embodiment of a system 100 for providing hybrid parallel-serial memory access to a multi-rank memory system. The system 100 may be implemented in any computing device, including a personal computer, a workstation, a server, or a portable computing device (PCD), such as a cellular telephone, a smart phone, a portable digital assistant (PDA), a portable game console, a tablet computer, or a battery-powered wearable device.

As illustrated in the embodiment of FIG. 1, the system 100 comprises a system on chip (SoC) 102 electrically coupled to a multi-rank memory system. The multi-rank memory system comprises two or more memory ranks. In the embodiment of FIG. 1, a dynamic random access memory (DRAM) system 104 comprises a first memory rank 124 (rank 0) and a second memory rank 126 (rank 1). Each of memory ranks 124 and 126 may comprise a set of DRAM chips on a separate die and connected to the same chip select. For example, memory rank 124 may be mounted on a first side of a printed circuit board (PCB), and memory rank 126 may be mounted on a second side of the PCB.

As illustrated in FIG. 1, the multi-rank memory system 104 is electrically coupled to the SoC 102 by both a parallel interface 130 and a serial interface 128 to provide hybrid parallel-serial memory access. The parallel interface 130 provides one or more parallel access channels. Data is transferred with multiple bits sent simultaneously over the parallel access channels (wires, frequency channels) within the same cable, or radio path, and synchronized to a clock. A variety of standards, protocols, or technologies may be used to perform the parallel transfer of the data, such as transfers to (or from) a double data rate synchronous dynamic random-access memory (DDR SDRAM) using the DDR4-2400 DDR4 standard (DDR4). Parallel access channels, such as DDR4, may provide various desirable characteristics including significantly lower latency.

The serial interface 128 provides one or more serial access channels that may be used to communicate data between the SoC 102 and the multi-rank memory system 104. A variety of standards, protocols, or technologies may be used to perform the serial transfer of the data. In an embodiment, the serial access channels may comprise a direct memory access (DMA) channel, such as, for example, a peripheral component interconnection express (PCIe) channel. As known in the art, a PCIe channel provides various desirable characteristics, such as, higher maximum system bus throughput, lower I/O pin count, less complexity in maintaining signal integrity, and a smaller physical footprint. However, PCIe is typically not used for system memory access because of the significantly greater initial setup latency required to transfer a given block of data between over the single channel. The latency of serial access channels, such as PCIe, can be significantly greater than the latency of parallel access channels, such as DDR4.

The SoC 102 comprises various on-chip components, including one or more memory clients, a DRAM controller 108, a cache 110, a static random access memory (SRAM) 112, and a read only memory (ROM) 114 interconnected via a SoC bus 116. The memory clients request memory resources (read and/or write requests) from the multi-rank memory system 104. The memory clients may comprise one or more processing units (*e.g.,* central processing unit (CPU) 106, a graphics processing unit (GPU), digital signal processor (DSP), *etc*.), a video encoder, or other clients requesting read/write access to the memory system.

The DRAM controller 108 may comprise a serial interface controller 122 and a parallel interface controller 120. The serial interface controller 122 controls the data transfer over one or more serial channels (serial interface 128). The parallel controller 120 controls the data transfer over one or more lanes of the parallel interface 130.

The system 100 further comprises a kernel memory allocator 132 of a high-level operating system (HLOS) 118. The memory allocator 132 comprises the logic and/or functionality for controlling allocation of memory to the memory ranks 124 and 126 in the multi-rank DRAM 104. As described below in more detail, the multi-rank DRAM 104 is partitioned into dedicated memory regions for providing serial access, parallel access, and hybrid parallel-serial access based on physical addresses with the serial access address range and the parallel access address range on different DRAM dies. The memory allocator 132 steers memory buffer allocation requests toward physical addresses at the different dedicated regions according to a memory bandwidth preference to optimize power and/or bandwidth of DRAM access. When requesting virtual memory page(s), a process may specify a "hint" to the memory allocator 132. When memory bandwidth performance is preferred or requested, the memory allocator 132 may fairly spread these "performance" requests across a dedicated serial access region in a first memory rank 124 and a dedicated parallel access region 126 in a second memory rank 126. In this manner, simultaneous memory access may be provided via the serial interface 128 and the parallel interface 130. When memory performance is not a factor, the memory allocator 132 may use dedicated parallel regions on either the memory rank 124 or the memory rank 126.

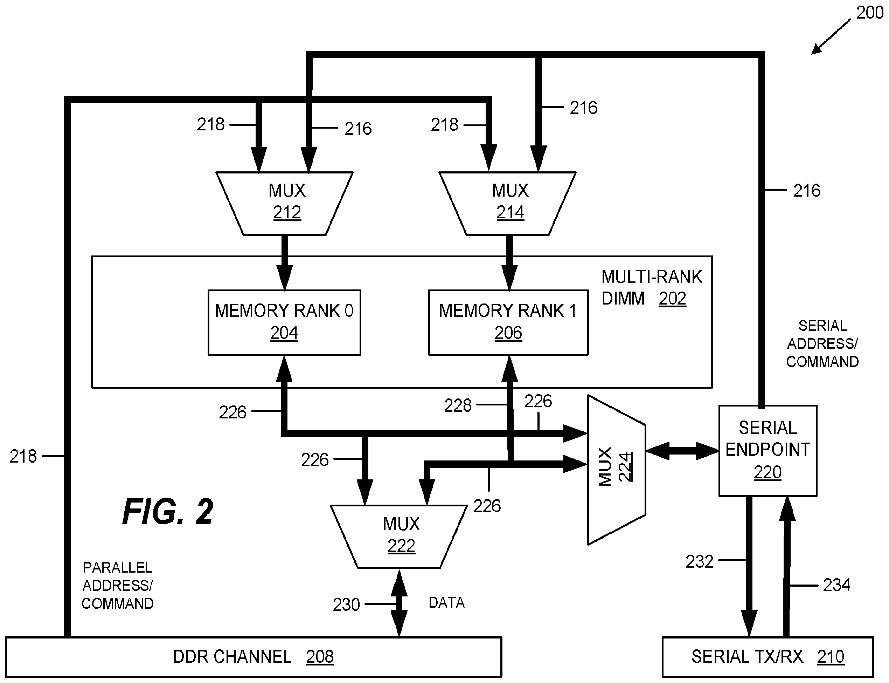

FIG. 2 illustrates an embodiment in which the multi-rank DRAM 104 comprises a dual inline memory module (DIMM) 202. Memory ranks 204 and 206 may be mounted on opposing sides of a printed circuit board (PCB) or otherwise stacked. Each memory rank has address/commands and data interfaces. The address/commands mux logic 212 receives address/commands either from serial endpoint 220 via bus 216, or from parallel DDR channel 208 via bus 218, during a particular operation period. The address/commands mux logic 212 then passes the address/commands to the memory rank0. The data interface 226 on memory rank 0 is connected to both parallel DDR channel via data mux logic 222, and serial endpoint 220 via data mux logic 224. The data mux logic 222 only inputs/outputs data 230 for the corresponding address/command that the DDR channel 208 sent via bus 218. The data mux logic 224 only inputs/outputs data for the corresponding address/command that the serial endpoint sent via bus 216.

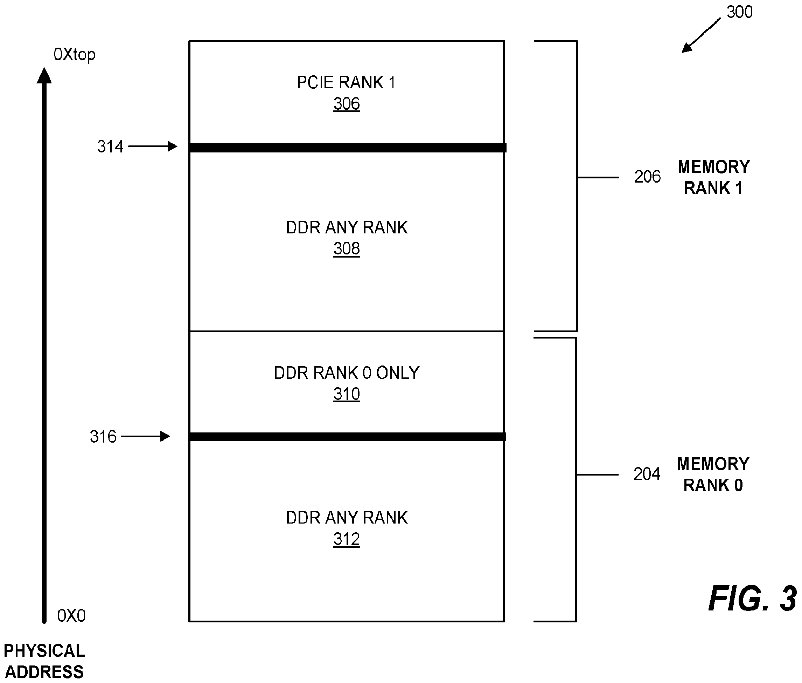

FIG. 3 illustrates an exemplary memory address map 300 for the multi-rank DIMM 202. Memory rank 206 (rank 1) is partitioned into a first region 306 dedicated to rank 1 serial access and a second region 308 dedicated to any rank parallel access. Memory rank 204 (rank 0) is partitioned into a third region 310 dedicated to rank 0 parallel access and a fourth region 312 dedicated to any rank parallel access. As illustrated in FIG. 3, the first region 306 may have a dynamic boundary 314 for adjusting the size of regions 306 and 308 in memory rank 206. The third region 310 may have a dynamic boundary 316 for adjusting the size of regions 310 and 312 in memory rank 204.

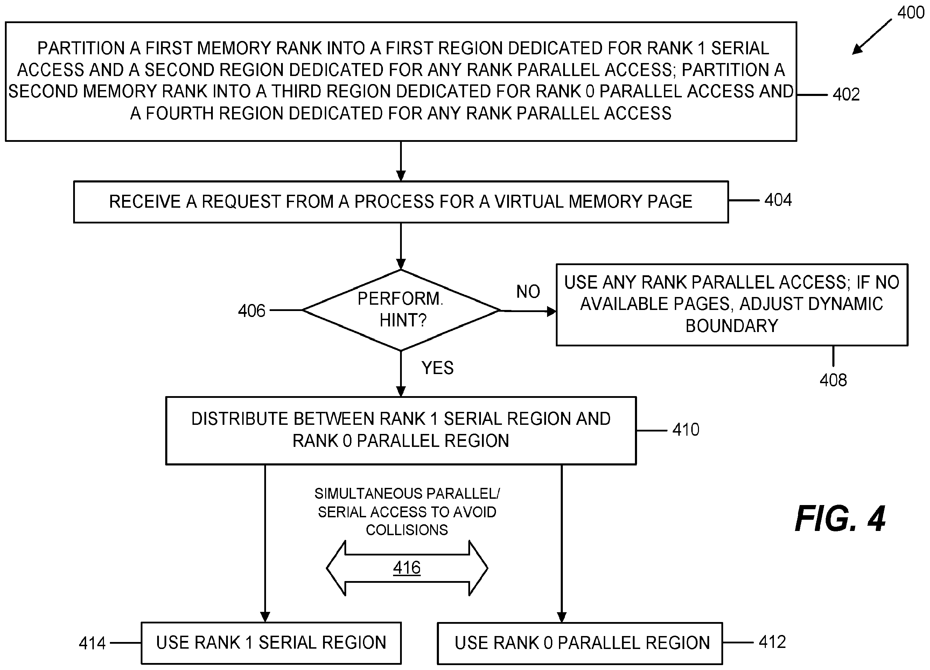

FIG. 4 is a flowchart illustrating an embodiment of a method 400 for allocating memory requests according to the memory address map 300. At block 402, memory ranks 206 and 204 may be partitioned as illustrated in FIG. 3 for hybrid parallel-serial memory access. At block 404, the memory allocator 132 receives a request from a process executing on CPU 106 for a virtual memory page (4 Kbyte page). The request may comprise a hint for indicating a preference for memory bandwidth performance. Processes needing higher performance may include, for example, gaming, image processing, or data computation with a high degree of precision, with a high number of data points/resolution, and or being repeatedly recalculated/refreshed at a very high refresh rate. For example, a virtual reality game may require very accurate color depth, a very large amount of pixels, and the display must be refreshed rapidly, leading to high memory bandwidth.

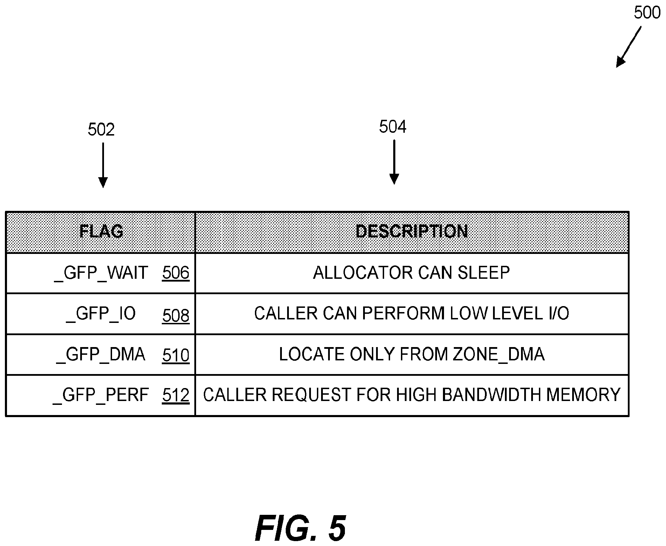

FIG. 5 is table 500 illustrating an exemplary flag structure 500 for providing a performance hint to the memory allocator 132. Column 502 lists flags 506, 508, 510, and 512 that may be specified in a request to memory allocator 132. A "_GFP_WAIT" flag 506 may be used to indicate that the memory allocator 132 may enter a sleep mode. A "_GFP_IO" flag 508 may be used to indicate a preference for low level bandwidth. A "_GFP_DMA" flag 510 may be used to indicate a preference for direct memory access. A "_GFP_PERF" flag 512 may be used to indicate the performance hint (*i.e.,* a preference for high bandwidth memory) to the memory allocator 132.

Referring again to FIG. 4, at decision block 406, the memory allocator 132 may determine whether a performance hint has been specified in the received request. If the request does not comprise a performance hint, at block 408, the memory allocator 132 may use any rank parallel access (*e.g.,* region 308 in memory rank 206 or region 312 in memory rank 204). If the corresponding region does not have any free physical pages, the dynamic boundary 314 and/or 316 may be adjusted to increase the size of the region 308/312 and correspondingly decrease the size of the region 306 and 310, respectively. If the request comprises a performance hint, at block 410, the memory allocator 132 may selectively assign the virtual memory page to a free physical page in the dedicated serial access region 306 (memory rank 206) and the dedicated parallel access region 310 (memory rank 204). In an embodiment, the memory allocator 132 may alternate between the dedicated serial access region 306 (block 414) and the dedicated parallel access region 310 (block 412). In this manner, as illustrated at arrow 416, the memory allocator 132 may simultaneously provide parallel and serial access to avoid memory collisions.

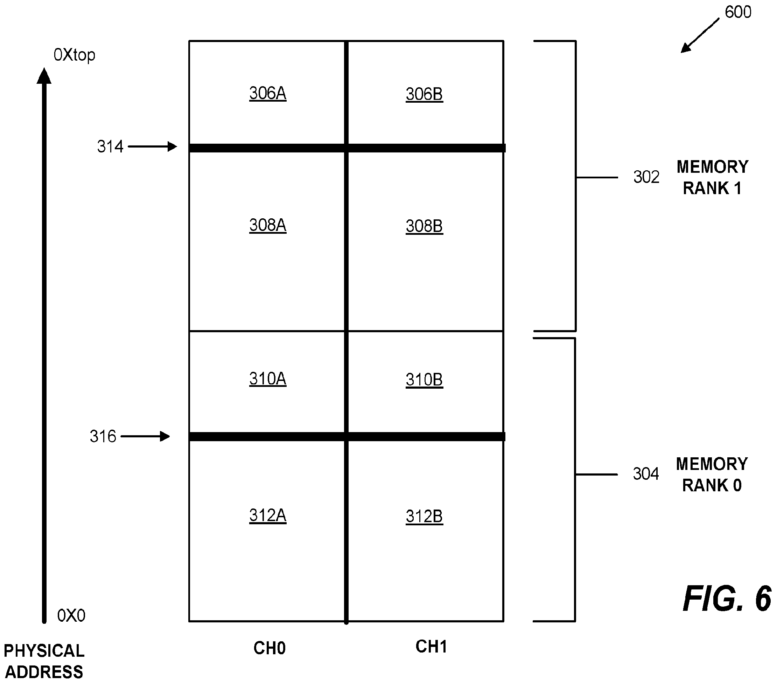

It should be appreciated that the memory allocation schemes described above may be extended to a dual channel embodiment. FIG. 6 illustrates an exemplary memory address map 600 for a dual channel embodiment. In this embodiment, the I/O interface selection may be independent on each channel (*i.e.,* channel 0 (CH0) and channel 1 (CH1)) if channel interleaving is not used. One of ordinary skill in the art will appreciate that channel interleaving may be performed in alternative embodiments. When channel interleaving is used, the same region in different channels, for example 306A on CH0 and 306B on CH1, may use the same interface, both serial interfaces, or both parallel interfaces. When channel interleaving is not used, CH0 may use the serial interface 128 while CH1 uses the parallel interface 130.

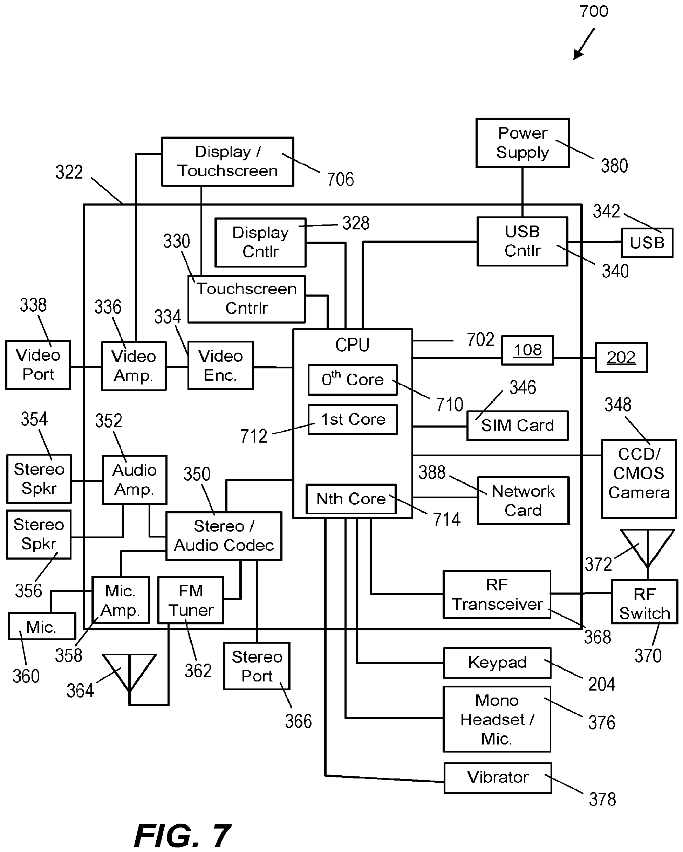

As mentioned above, the system 100 may be incorporated into any desirable computing system. FIG. 7 illustrates the system 100 incorporated in an exemplary portable computing device (PCD) 700. It will be readily appreciated that certain components of the system 100 (*e.g.,* cache 120, cache controller 114, DRAM controller 116) are included on the SoC 322 (FIG. 7) while other components (*e.g.,* the DRAM 104) are external components coupled to the SoC 322. The SoC 322 may include a multicore CPU 702. The multicore CPU 702 may include a zeroth core 710, a first core 712, and an Nth core 714. One of the cores may comprise, for example, a graphics processing unit (GPU) with one or more of the others comprising the CPU.

A display controller 328 and a touch screen controller 330 may be coupled to the CPU 1602. In turn, the touch screen display 706 external to the on-chip system 322 may be coupled to the display controller 328 and the touch screen controller 330.

FIG. 7 further shows that a video encoder 334, e.g., a phase alternating line (PAL) encoder, a sequential color a memoire (SECAM) encoder, or a national television system(s) committee (NTSC) encoder, is coupled to the multicore CPU 702. Further, a video amplifier 336 is coupled to the video encoder 334 and the touch screen display 606. Also, a video port 338 is coupled to the video amplifier 336. As shown in FIG. 7, a universal serial bus (USB) controller 340 is coupled to the multicore CPU 702. Also, a USB port 342 is coupled to the USB controller 340. Memory 104 and a subscriber identity module (SIM) card 346 may also be coupled to the multicore CPU 702.

Further, as shown in FIG. 7, a digital camera 348 may be coupled to the multicore CPU 702. In an exemplary aspect, the digital camera 348 is a charge-coupled device (CCD) camera or a complementary metal-oxide semiconductor (CMOS) camera.

As further illustrated in FIG. 7, a stereo audio coder-decoder (CODEC) 350 may be coupled to the multicore CPU 702. Moreover, an audio amplifier 352 may be coupled to the stereo audio CODEC 350. In an exemplary aspect, a first stereo speaker 354 and a second stereo speaker 356 are coupled to the audio amplifier 352. FIG. 7 shows that a microphone amplifier 358 may be also coupled to the stereo audio CODEC 350. Additionally, a microphone 360 may be coupled to the microphone amplifier 358. In a particular aspect, a frequency modulation (FM) radio tuner 362 may be coupled to the stereo audio CODEC 350. Also, an FM antenna 364 is coupled to the FM radio tuner 362. Further, stereo headphones 366 may be coupled to the stereo audio CODEC 350.

FIG. 7 further illustrates that a radio frequency (RF) transceiver 368 may be coupled to the multicore CPU 7. An RF switch 370 may be coupled to the RF transceiver 368 and an RF antenna 372. A keypad 204 may be coupled to the multicore CPU 702. Also, a mono headset with a microphone 376 may be coupled to the multicore CPU 702. Further, a vibrator device 378 may be coupled to the multicore CPU 702.

FIG. 7 also shows that a power supply 380 may be coupled to the on-chip system 322. In a particular aspect, the power supply 380 is a direct current (DC) power supply that provides power to the various components of the PCD 700 that require power. Further, in a particular aspect, the power supply is a rechargeable DC battery or a DC power supply that is derived from an alternating current (AC) to DC transformer that is connected to an AC power source.

FIG. 7 further indicates that the PCD 700 may also include a network card 388 that may be used to access a data network, e.g., a local area network, a personal area network, or any other network. The network card 388 may be a Bluetooth network card, a WiFi network card, a personal area network (PAN) card, a personal area network ultra-low-power technology (PeANUT) network card, a television/cable/satellite tuner, or any other network card well known in the art. Further, the network card 388 may be incorporated into a chip, *i.e.,* the network card 388 may be a full solution in a chip, and may not be a separate network card 388.

As depicted in FIG. 7, the touch screen display 706, the video port 338, the USB port 342, the camera 348, the first stereo speaker 354, the second stereo speaker 356, the microphone 360, the FM antenna 364, the stereo headphones 366, the RF switch 370, the RF antenna 372, the keypad 374, the mono headset 376, the vibrator 378, and the power supply 380 may be external to the on-chip system 322.

It should be appreciated that one or more of the method steps described herein may be stored in the memory as computer program instructions, such as the modules described above. These instructions may be executed by any suitable processor in combination or in concert with the corresponding module to perform the methods described herein.

Certain steps in the processes or process flows described in this specification naturally precede others for the invention to function as described. However, the invention is not limited to the order of the steps described if such order or sequence does not alter the functionality of the invention. That is, it is recognized that some steps may performed before, after, or parallel (substantially simultaneously with) other steps without departing from the scope of the appended claims. In some instances, certain steps may be omitted or not performed without departing from the invention. Further, words such as "thereafter", "then", "next", etc. are not intended to limit the order of the steps. These words are simply used to guide the reader through the description of the exemplary method.

Additionally, one of ordinary skill in programming is able to write computer code or identify appropriate hardware and/or circuits to implement the disclosed invention without difficulty based on the flow charts and associated description in this specification, for example.

Therefore, disclosure of a particular set of program code instructions or detailed hardware devices is not considered necessary for an adequate understanding of how to make and use the invention. The inventive functionality of the claimed computer implemented processes is explained in more detail in the above description and in conjunction with the Figures which may illustrate various process flows.

In one or more exemplary aspects, the functions described may be implemented in hardware, software, firmware, or any combination thereof. If implemented in software, the functions may be stored on or transmitted as one or more instructions or code on a computer-readable medium. Computer-readable media include both computer storage media and communication media including any medium that facilitates transfer of a computer program from one place to another. A storage media may be any available media that may be accessed by a computer. By way of example, and not limitation, such computer-readable media may comprise RAM, ROM, EEPROM, NAND flash, NOR flash, M-RAM, P-RAM, R-RAM, CD-ROM or other optical disk storage, magnetic disk storage or other magnetic storage devices, or any other medium that may be used to carry or store desired program code in the form of instructions or data structures and that may be accessed by a computer.

Also, any connection is properly termed a computer-readable medium. For example, if the software is transmitted from a website, server, or other remote source using a coaxial cable, fiber optic cable, twisted pair, digital subscriber line ("DSL"), or wireless technologies such as infrared, radio, and microwave, then the coaxial cable, fiber optic cable, twisted pair, DSL, or wireless technologies such as infrared, radio, and microwave are included in the definition of medium.

Disk and disc, as used herein, includes compact disc ("CD"), laser disc, optical disc, digital versatile disc ("DVD"), floppy disk and blu-ray disc where disks usually reproduce data magnetically, while discs reproduce data optically with lasers. Combinations of the above should also be included within the scope of computer-readable media.

Alternative embodiments will become apparent to one of ordinary skill in the art to which the invention pertains without departing from its spirit and scope. Therefore, although selected aspects have been illustrated and described in detail, it will be understood that various substitutions and alterations may be made therein without departing from the scope of the following claims.

## Claims

1. A method (400) for allocating memory in a hybrid parallel/serial memory system, the method comprising:
configuring (402) a memory address map (300) for a multi-rank memory system with a dedicated serial access region (306) in a first memory rank (124, 204) and a dedicated parallel access region (310) in a second memory rank (126, 206);
receiving (404) a request for a virtual memory page; and
if the request comprises a performance hint, selectively assigning (410) the virtual memory page to both a free physical page in the dedicated serial access region in the first memory rank via a serial access interface (128) and the dedicated parallel access region in the second memory rank via a parallel access interface (130),
wherein the memory address map comprises an additional dedicated parallel access region (308, 312) in one or more of the first and second memory ranks.

2. The method (400) of claim 1, wherein the multi-rank memory system comprises a multi-rank dual inline memory module, DIMM, (202) electrically coupled to a system on chip, SoC (102, 322).

3. The method (400) of claim 1, wherein the multi-rank memory system comprises a dynamic random access memory, DRAM (104).

4. The method (400) of claim 1, wherein the serial access interface comprises a high-speed serial expansion bus (216), and the parallel access interface comprises a double data rate, DDR, bus (218).

5. The method (400) of claim 1, further comprising:
if the request does not comprise the performance hint, allocating (408) the request to the additional dedicated parallel access region (308, 312).

6. The method (400) of claim 1, wherein the selectively assigning (410) the virtual memory page to the free physical page in the serial access region (306) and the parallel access region (310) comprises:
determining one of the dedicated serial access region and the dedicated parallel access region is currently being accessed by a previous request; and
assigning the virtual memory page to the free physical page in the other of the dedicated serial access region and the dedicated parallel access region to avoid a memory collision.

7. The method (400) of claim 1, wherein the performance hint comprises a kernel flag (500).

8. A system (100, 700) for allocating memory in a hybrid parallel/serial memory system, the system comprising:
means for configuring (106, 702) a memory address map (300) for a multi-rank memory system with a dedicated serial access region (306) in a first memory rank (124, 204) and a dedicated parallel access region (310) in a second memory rank (126, 206);
means for receiving (132) a request for a virtual memory page; and
means for selectively assigning (132) the virtual memory page to both a free physical page in the dedicated serial access region in the first memory rank via a serial access interface (128) and the dedicated parallel access region in the second memory rank via a serial access interface (130) if the request comprises a performance hint,
wherein the memory address map (300) comprises an additional dedicated parallel access region (308, 312) in one or more of the first and second memory ranks.

9. The system (100, 700) of claim 8, wherein the multi-rank memory system comprises a multi-rank dual inline memory module, DIMM, (202) electrically coupled to a system on chip, SoC (102, 322).

10. The system (100, 700) of claim 8, wherein the multi-rank memory system comprises a dynamic random access memory, DRAM(104).

11. The system (100, 700) of claim 8, wherein the serial access interface comprises a high-speed serial expansion bus (216), and the parallel access interface a double data rate, DDR bus (218).

12. The system (100, 700) of claim 8, further comprising:
means for allocating (132) the request to the additional dedicated parallel access region (308, 312) if the request does not comprise the performance hint.

13. The system (100, 700) of claim8, wherein the means for selectively assigning (132) the virtual memory page to the free physical page in the serial access region (306) and the parallel access region (310) comprises:
means for determining one of the dedicated serial access region and the dedicated parallel access region is currently being accessed by a previous request; and
means for assigning the virtual memory page to the free physical page in the other of the dedicated serial access region and the dedicated parallel access region to avoid a memory collision.

14. The system (100, 700) of claim 8, wherein the performance hint comprises a kernel flag (500).

15. A computer program comprising instructions for causing a computer system to perform the method steps of any of claims 1 to 7 when executed on the computer system, wherein said computer program is incorporated in a portable communication device (700).

## Patentansprüche

1. Verfahren (400) zum Zuweisen von Speicher in einem hybriden parallelen/seriellen Speichersystem, wobei das Verfahren umfasst:
Konfigurieren (402) einer Speicheradresskarte (300) für ein Mehrrang-Speichersystem mit einem dedizierten seriellen Zugriffsbereich (306) in einem ersten Speicherrang (124, 204) und einem dedizierten parallelen Zugriffsbereich (310) in einem zweiten Speicherrang (126, 206);
Empfangen (404) einer Anforderung für eine virtuelle Speicherseite; und
wenn die Anforderung einen Leistungshinweis umfasst, selektives Zuweisen (410) der virtuellen Speicherseite sowohl einer freien physikalischen Seite in dem dedizierten seriellen Zugriffsbereich in dem ersten Speicherrang über eine serielle Zugriffsschnittstelle (128) und des dedizierten parallelen Zugriffsbereichs in dem zweiten Speicherrang über eine Parallelzugriffsschnittstelle (130),
wobei die Speicheradresskarte einen zusätzlichen dedizierten Parallelzugriffsbereich (308, 312) in einem oder mehreren der ersten und zweiten Speicherränge umfasst.

2. Verfahren (400) nach Anspruch 1, wobei das Mehrrangspeichersystem ein Mehrrang-Dual-Inline-Speichermodul, DIMM, (202) umfasst, das elektrisch mit einem System auf Chip, SoC (102, 322), gekoppelt ist.

3. Verfahren (400) nach Anspruch 1, wobei das Mehrrangspeichersystem einen dynamischen Zufalls-Zugriffsspeicher, DRAM (104), umfasst.

4. Verfahren (400) nach Anspruch 1, wobei die serielle Zugriffsschnittstelle einen Hochgeschwindigkeit seriellen Erweiterungsbus (216) und die parallele Zugriffsschnittstelle einen doppelten Datenraten-, DDR, Bus (218) umfasst.

5. Verfahren (400) nach Anspruch 1, ferner umfassend:
wenn die Anforderung nicht den Leistungshinweis umfasst, Zuordnen (408) der Anforderung zu dem zusätzlichen dedizierten Parallelzugriffsbereich (308, 312).

6. Verfahren (400) nach Anspruch 1, wobei das selektive Zuweisen (410) der virtuellen Speicherseite zu der freien physikalischen Seite in dem seriellen Zugriffsbereich (306) und dem parallelen Zugriffsbereich (310) umfasst:
Bestimmen, dass auf einen von dem dedizierten seriellen Zugriffsbereich und dem dedizierten parallelen Zugriffsbereich derzeit durch eine vorherige Anforderung zugegriffen wird; und
Zuweisen der virtuellen Speicherseite zu der freien physikalischen Seite in dem anderen von dem dedizierten seriellen Zugriffsbereich und dem dedizierten parallelen Zugriffsbereich, um eine Speicherkollision zu vermeiden.

7. Verfahren (400) nach Anspruch 1, wobei der Leistungshinweis ein Kernel-Flag (500) umfasst.

8. System (100, 700) zum Zuweisen von Speicher in einem hybriden parallelen/seriellen Speichersystem, wobei das System umfasst:
Mittel zum Konfigurieren (106, 702) einer Speicheradresskarte (300) für ein Mehrrang-Speichersystem mit einem dedizierten seriellen Zugriffsbereich (306) in einem ersten Speicherrang (124, 204) und einem dedizierten parallelen Zugriffsbereich (310) in einem zweiten Speicherrang (126, 206);
Mittel zum Empfangen (132) einer Anforderung für eine virtuelle Speicherseite; und
Mittel zum selektiven Zuweisen (132) der virtuellen Speicherseite sowohl einer freien physikalischen Seite in dem dedizierten seriellen Zugriffsbereich in dem ersten Speicherrang über eine serielle Zugriffsschnittstelle (128) und des dedizierten parallelen Zugriffsbereichs in dem zweiten Speicherrang über eine Parallelzugriffsschnittstelle (130), wenn die Anforderung einen Leistungshinweis umfasst,
wobei die Speicheradresskarte (300) einen zusätzlichen dedizierten Parallelzugriffsbereich (308, 312) in einem oder mehreren der ersten und zweiten Speicherränge umfasst.

9. System (100, 700) nach Anspruch 8, wobei das Mehrrangspeichersystem ein Mehrrang-Dual-Inline-Speichermodul, DIMM, (202) umfasst, das elektrisch mit einem System auf Chip, SoC (102, 322), gekoppelt ist.

10. System (100, 700) nach Anspruch 8, wobei das Mehrrangspeichersystem einen dynamischen Zufalls-Zugriffsspeicher, DRAM (104), umfasst.

11. System (100, 700) nach Anspruch 8, wobei die serielle Zugriffsschnittstelle einen Hochgeschwindigkeit seriellen Erweiterungsbus (216) und die parallele Zugriffsschnittstelle einen doppelten Datenraten-, DDR, Bus (218) umfasst.

12. System (100, 700) nach Anspruch 8, ferner umfassend:
Mittel zum Zuordnen (132) der Anforderung zu dem zusätzlichen dedizierten Parallelzugriffsbereich (308, 312), wenn die Anforderung nicht den Leistungshinweis umfasst.

13. System (100, 700) nach Anspruch 8, wobei das Mittel zum selektiven Zuweisen (132) der virtuellen Speicherseite zu der freien physikalischen Seite in dem seriellen Zugriffsbereich (306) und dem parallelen Zugriffsbereich (310) umfasst:
Mittel zum Bestimmen, dass auf einen von dem dedizierten seriellen Zugriffsbereich und dem dedizierten parallelen Zugriffsbereich derzeit durch eine vorherige Anforderung zugegriffen wird; und
Mittel zum Zuweisen der virtuellen Speicherseite zu der freien physikalischen Seite in dem anderen von dem dedizierten seriellen Zugriffsbereich und dem dedizierten parallelen Zugriffsbereich, um eine Speicherkollision zu vermeiden.

14. System (100, 700) nach Anspruch 8, wobei der Leistungshinweis ein Kernel-Flag (500) umfasst.

15. Computerprogramm, umfassend Anweisungen, um ein Computersystem zu veranlassen, die Verfahrensschritte eines der Ansprüche 1 bis 7 auszuführen, wenn es auf dem Computersystem ausgeführt wird, wobei das Computerprogramm in eine tragbare Kommunikationsvorrichtung (700) integriert ist.

## Revendications

1. Un procédé (400) pour attribuer de la mémoire dans un système de mémoire hybride parallèle/série, le procédé comprenant :
la configuration (402) d'une carte d'adressage mémoire (300) pour un système de mémoire à rangs multiples avec une région d'accès en série dédiée (306) d'un premier rang de mémoire (124, 204) et une région d'accès en parallèle dédiée (310) d'un deuxième rang de mémoire (126, 206) ;
la réception (404) d'une requête de page mémoire virtuelle ; et
si la requête comprend une indication de performance, l'attribution sélective (410) de la page de mémoire virtuelle à la fois à une page physique libre dans la région d'accès en série dédiée du premier rang de mémoire via une interface d'accès en série (128) et dans la région d'accès en parallèle dédiée du deuxième rang de mémoire via une interface d'accès en parallèle (130),
dans lequel la carte d'adressage mémoire comprend une région d'accès en parallèle dédiée additionnelle (308, 312) d'un ou plusieurs des premier et deuxième rangs de mémoire.

2. Le procédé (400) selon la revendication 1, dans lequel le système de mémoire à rangs multiples comprend un module de mémoire à double rangée de connexions, DIMM, à rangs multiples (202), électriquement couplé à un système sur puce, SoC (102, 322).

3. Le procédé (400) selon la revendication 1, dans lequel le système de mémoire à rangs multiples comprend une mémoire vive dynamique, DRAM (104).

4. Le procédé (400) selon la revendication 1, dans lequel l'interface d'accès en série comprend un bus d'extension série à grande vitesse (216), et l'interface d'accès en parallèle comprend un bus à double débit de données, DDR (218).

5. Le procédé (400) selon la revendication 1, comprenant en outre :
si la requête ne comprend pas l'indication de performance, l'attribution (408) de la requête à la région d'accès en parallèle dédiée additionnelle (308, 312).

6. Le procédé (400) selon la revendication 1, dans lequel l'attribution sélective (410) de la page de mémoire virtuelle à la page physique libre dans la région d'accès en série (306) et la région d'accès en parallèle (310) comprend :
la détermination que l'une de la région d'accès en série dédiée et de la région d'accès en parallèle dédiée est actuellement en cours d'accès par une requête précédente ; et
l'attribution de la page de mémoire virtuelle à la page physique libre dans l'autre de la région d'accès en série dédiée et de la région d'accès en parallèle dédiée pour éviter une collision dans la mémoire.

7. Le procédé (400) selon la revendication 1, dans lequel l'indication de performance comprend un drapeau de noyau (500).

8. Un système (100, 700) pour attribuer de la mémoire dans un système de mémoire hybride parallèle/série, le système comprenant :
un moyen de configuration (106, 702) d'une carte d'adressage mémoire (300) pour un système de mémoire à rangs multiples avec une région d'accès en série dédiée (306) d'un premier rang de mémoire (124, 204) et une région d'accès en parallèle dédiée (310) d'une deuxième rang de mémoire (126, 206) ;
un moyen de réception (132) d'une requête de page de mémoire virtuelle ; et
un moyen d'attribution sélective (132) de la page de mémoire virtuelle à la fois à une page physique libre dans la région d'accès en série dédiée du premier rang de mémoire via une interface d'accès en série (128) et dans la région d'accès en parallèle dédiée du deuxième rang de mémoire via une interface d'accès en parallèle (130) si la requête comprend une indication de performance,
dans lequel la carte d'adressage mémoire (300) comprend une région d'accès en parallèle dédiée additionnelle (308, 312) d'un ou plusieurs des premier et deuxième rangs de mémoire.

9. Le système (100, 700) selon la revendication 8, dans lequel le système de mémoire à rangs multiples comprend un module de mémoire à double rangée de connexions, DIMM, à rangs multiples (202), électriquement couplé à un système sur puce, SoC (102, 322).

10. Le système (100, 700) selon la revendication 8, dans lequel le système de mémoire à rangs multiples comprend une mémoire vive dynamique, DRAM (104).

11. Le système (100, 700) selon la revendication 8, dans lequel l'interface d'accès en série comprend un bus d'extension en série à grande vitesse (216), et l'interface d'accès en parallèle un bus à double débit de données, DDR (218).

12. Le système (100, 700) selon la revendication 8, comprenant en outre :
un moyen d'attribution (132) de la requête à la région d'accès en parallèle dédiée additionnelle (308, 312) si la requête ne comprend pas l'indication de performance.

13. Le système (100, 700) selon la revendication 8, dans lequel le moyen d'attribution sélective (132) de la page de mémoire virtuelle à la page physique libre dans la région d'accès en série (306) et la région d'accès en parallèle (310) comprend :
un moyen de détermination que l'une de la région d'accès en série dédiée et de la région d'accès en parallèle dédiée est actuellement en cours d'accès par une requête précédente ; et
un moyen d'attribution de la page de mémoire virtuelle à la page physique libre dans l'autre de la région d'accès en série dédiée et de la région d'accès en parallèle dédiée pour éviter une collision dans la mémoire.

14. Le système (100, 700) selon la revendication 8, dans lequel l'indication de performance comprend un drapeau de noyau (500).

15. Un programme informatique comprenant des instructions pour amener un système informatique à réaliser les étapes de procédé de l'une des revendications 1 à 7 lorsqu'elles sont exécutées sur le système informatique, dans lequel ledit programme informatique est incorporé à un dispositif portable de communication (700).
